# DEMANDE DE BREVET EUROPEEN

(11) **EP 2 884 543 A1**
(43) Date de publication de la demande: **17.06.2015**
(21) Numéro de dépôt: 14198019.3
(22) Date de dépôt: 15.12.2014
(51) Int. Cl.: H01L 31/0224, H01L 31/068, H01L 31/072

(54) **Cellule photovoltaïque et son procédé de formation**

(30) Priorité: 16.12.2013 FR 1362680
(71) Demandeur: Commissariat à l'Énergie Atomique et aux Énergies Alternatives, 75015 Paris (FR)
(72) Inventeur: Cabal, Raphaël, 73000 Chambery (FR); Desrues, Thibaut, 76130 Mont Saint Aignan (FR)
(74) Mandataire: Brevalex

(57) **Abrégé**

L'invention concerne une cellule photovoltaïque comprenant un substrat semi-conducteur (1) dopé selon un premier type de conductivité ; une première région semi-conductrice (3), dopée selon un second type de conductivité, s'étendant à partir d'une des faces (5) du substrat, dans ou sur le substrat ; au moins un contact conducteur (7) disposé sur la première région semi-conductrice ; et une seconde région semi-conductrice (9), dopée selon le second type de conductivité, recouvrant au moins l'au moins un contact conducteur et étant en contact avec la première région semi-conductrice et/ou le substrat.

## Description

### DOMAINE TECHNIQUE

La présente invention concerne une cellule photovoltaïque et un procédé de formation d'une cellule photovoltaïque.

### ÉTAT DE LA TECHNIQUE ANTÉRIEURE

Les contacts électriques d'une cellule photovoltaïque sont couramment disposés sur chacune des faces principales de la cellule, sur la face exposée au rayonnement lumineux et sur la face non exposée.

Afin d'augmenter les performances des cellules photovoltaïques, une solution consiste à minimiser la perte de photogénération de porteurs de charges due aux contacts électriques disposés sur la face exposée au rayonnement lumineux.

Pour cela, des structures de cellules photovoltaïques couramment désignées par les acronymes d'origine anglo-saxonne MWT (« Metal Wrap Through ») et EWT (« Emitter Wrap Through ») ont été proposées. Une partie des métallisations destinées à contacter des zones dopées de la face exposée sont disposées sur la face non exposée. Des vias conducteurs traversant le substrat permettent de relier électriquement les métallisations situées sur la face non exposée aux zones dopées à contacter de la face exposée.

Un inconvénient de telles cellules photovoltaïques réside dans la complexité de leur procédé de fabrication (réalisation de vias à travers le substrat, isolation entre des régions dopées selon des types de conductivité opposés sur une même face, alignement des métallisations). En outre, la mise en module de telles cellules photovoltaïques requiert la réalisation de connexions spécifiques.

Des structures dites « à contacts arrière », telles que des structures couramment désignées par les acronymes d'origine anglo-saxonne RCC (« Rear Contact Cell ») et IBC (« Interdigitated Back Contact »), ont également été proposées. Toutes les zones dopées à contacter sont disposées sur la face non exposée, et donc les métallisations destinées à contacter ces zones dopées sont également disposées sur la face non exposée.

Un avantage des cellules photovoltaïques à contacts arrière réside dans le fait que les contacts électriques n'entraînent pas de perte de photogénération puisqu'ils sont disposés sur la face non exposée.

Un inconvénient des cellules photovoltaïques à contacts arrière est lié à l'absence de dispositif de collecte à proximité du lieu de photogénération des porteurs de charges. Les porteurs de charges doivent traverser le substrat pour rejoindre la face non exposée où se situent tous les contacts. Les porteurs de charges risquent alors de se recombiner en présence de défauts dans le substrat. La fabrication de telles cellules photovoltaïques requiert donc l'utilisation de substrats semi-conducteurs présentant d'excellentes propriétés électriques.

Un autre inconvénient des cellules photovoltaïques à contacts arrière réside dans la complexité de leur procédé de fabrication et de leur mise en module.

Un inconvénient des deux types de cellules photovoltaïques décrits ci-dessus est lié au fait qu'il convient non seulement de former localement des zones dopées de types de conductivité opposés mais également de les isoler entre elles pour éviter des court-circuits de la cellule. Il en résulte une augmentation du coût de fabrication de telles cellules photovoltaïques.

Il se pose donc le problème de réaliser une cellule photovoltaïque permettant de minimiser la perte de photogénération de porteurs de charges due aux contacts électriques disposés sur la face exposée au rayonnement lumineux.

Il se pose également le problème de réaliser une cellule photovoltaïque présentant des performances accrues.

Il se pose en outre le problème de réaliser une telle cellule photovoltaïque par un procédé simple à mettre en oeuvre.

### EXPOSÉ DE L'INVENTION

La présente invention vise notamment à résoudre ces problèmes.

La présente invention concerne une cellule photovoltaïque comportant une région de photogénération supplémentaire, en plus du substrat et de l'émetteur, recouvrant les contacts électriques disposés sur la face destinée à être exposée au rayonnement lumineux. Une telle région de photogénération peut être considérée comme un émetteur supplémentaire.

La présente invention concerne d'abord une cellule photovoltaïque comprenant un substrat semi-conducteur dopé selon un premier type de conductivité ; une première région semi-conductrice, dopée selon un second type de conductivité, s'étendant à partir d'une des faces du substrat, dans ou sur le substrat; au moins un contact conducteur disposé sur la première région semi-conductrice ; et une seconde région semi-conductrice, dopée selon le second type de conductivité, recouvrant au moins l'au moins un contact conducteur et étant en contact avec la première région semi-conductrice et/ou le substrat.

Un avantage d'une cellule photovoltaïque du type de celle décrite ci-dessus réside dans le fait qu'elle peut être fabriquée à partir d'un substrat semi-conducteur quelconque, de type de conductivité P ou N et quelle que soit sa qualité (métallurgique, électronique, multicristallin, monocristallin).

Un autre avantage d'une telle cellule photovoltaïque réside dans le fait qu'elle ne requiert pas de via traversant le substrat.

Un autre avantage d'une telle cellule photovoltaïque réside dans le fait qu'elle ne requiert pas d'isolation entre des zones dopées de types de conductivité opposés.

Selon un mode de réalisation de la présente invention, le niveau de dopage de la seconde région semi-conductrice est supérieur à celui de la première région semi-conductrice.

La seconde région semi-conductrice peut présenter un gradient de dopage, le niveau de dopage de la seconde région semi-conductrice diminuant à partir de la surface en contact avec l'au moins un contact conducteur.

Selon un mode de réalisation de la présente invention, la première région semi-conductrice recouvre ladite face du substrat, et la première région semi-conductrice est recouverte d'une couche conductrice transparente, l'au moins un contact conducteur étant disposé sur la couche conductrice transparente.

La seconde région semi-conductrice peut recouvrir entièrement la première région semi-conductrice. Dans ce cas, le niveau de dopage de la seconde région semi-conductrice est supérieur à celui de la première région semi-conductrice. Ceci permet la migration jusqu'au substrat des porteurs majoritaires (du point de vue du substrat) photogénérés dans la seconde région semi-conductrice.

Selon un mode de réalisation, la seconde région semi-conductrice est en contact seulement partiellement avec la première région semi-conductrice.

Par exemple, la seconde région semi-conductrice peut recouvrir seulement des première et seconde zones disposées de part et d'autre de l'au moins un contact conducteur.

Dans une cellule photovoltaïque selon l'invention, la première région semi-conductrice peut être continue, dans ou sur le substrat et sous le contact conducteur.

Selon un autre mode de réalisation de la présente invention, la première région semi-conductrice recouvre ladite face du substrat, excepté des première et seconde zones disposées de part et d'autre de l'au moins un contact conducteur, la seconde région semi-conductrice étant en contact direct avec les première et seconde zones du substrat.

Selon une variante de la présente invention, la première région semi-conductrice s'étend dans le substrat et est interrompue par une première et une seconde zones du substrat, dopées selon le premier type de conductivité, lesdites première et seconde zones étant disposées en bordure de l'au moins un contact conducteur de part et d'autre de l'au moins un contact conducteur, la seconde région semi-conductrice étant en contact direct avec les première et seconde zones du substrat.

L'au moins un contact conducteur peut être enterré dans le substrat.

La présente invention concerne en outre un procédé de formation d'une cellule photovoltaïque, notamment d'une cellule photovoltaïque du type qui vient d'être décrit ci-dessus, selon l'un ou l'autre de ses modes de réalisation, comprenant les étapes suivantes :
a) former, à partir d'une des faces d'un substrat semi-conducteur dopé selon un premier type de conductivité, une première région semi-conductrice dopée selon un second type de conductivité, dans ou sur le substrat ;
b) former au moins un contact conducteur sur la première région semi-conductrice ; et
c) recouvrir au moins l'au moins un contact conducteur d'une seconde région semi-conductrice, dopée selon le second type de conductivité, de façon que la seconde région semi-conductrice soit en contact avec la première région semi-conductrice et/ou le substrat.

Selon un mode de réalisation de la présente invention, le niveau de dopage de la seconde région semi-conductrice est supérieur à celui de la première région semi-conductrice.

La seconde région semi-conductrice peut présenter un gradient de dopage, le niveau de dopage de la seconde région semi-conductrice diminuant à partir de la surface en contact avec l'au moins un contact conducteur.

Selon un mode de réalisation de la présente invention, lors de l'étape a), on forme la première région semi-conductrice par voie thermique, dans le substrat.

Selon un mode de réalisation de la présente invention, lors de l'étape a), on forme la première région semi-conductrice par dépôt, sur ladite face du substrat. Entre les étapes a) et b), on peut recouvrir la première région semi-conductrice d'une couche conductrice transparente.

Lors de l'étape c), la seconde région semi-conductrice peut recouvrir entièrement la première région semi-conductrice ou la couche conductrice transparente.

Dans un procédé selon l'invention, la première région semi-conductrice peut être réalisée de manière à être continue, dans ou sur le substrat et sous le contact conducteur.

Selon un autre mode de réalisation, on peut réaliser la première région semi-conductrice afin que celle-ci recouvre ladite face du substrat, excepté des première et seconde zones disposées de part et d'autre de l'au moins un contact conducteur, la seconde région semi-conductrice étant en contact direct avec les première et seconde zones du substrat.

En variante, on réalise la première région semi-conductrice dans le substrat, afin que celle-ci soit interrompue par une première et une seconde zones du substrat, dopées selon le premier type de conductivité, lesdites première et seconde zones étant disposées en bordure de l'au moins un contact conducteur de part et d'autre de l'au moins un contact conducteur, la seconde région semi-conductrice étant en contact direct avec les première et seconde zones du substrat.

Lors de l'étape c), la seconde région semi-conductrice peut être réalisée de manière recouvrir entièrement la première région semi-conductrice ou la couche conductrice transparente.

Selon un mode de réalisation de la présente invention, avant l'étape a) de formation de la première région semi-conductrice, on forme au moins une cavité à partir de ladite face du substrat, et lors de l'étape b), on forme l'au moins un contact conducteur dans ladite au moins une cavité.

Dans les différents modes de réalisation d'un dispositif selon l'invention, la seconde région semi-conductrice recouvre, éventuellement seulement, une, ou la, ou les surface(s) du contact conducteur destinée(s) à être exposée(s) au rayonnement lumineux, autrement dit les surfaces libres du contact, tout en étant en contact avec la première région semi-conductrice et/ou le substrat.

Dans les différents modes de réalisation d'un procédé selon l'invention, on recouvre, éventuellement seulement, au moins une, ou la, ou les, surface(s) de l'au moins un contact conducteur, d'une seconde région semi-conductrice, dopée selon le second type de conductivité, de façon que la seconde région semi-conductrice soit en contact avec la première région semi-conductrice et/ou le substrat.

### BRÈVE DESCRIPTION DES DESSINS

D'autres caractéristiques et avantages de l'invention ressortiront plus clairement à la lecture de la description suivante et en référence aux dessins annexés, donnés à titre uniquement illustratif et nullement limitatifs.
La figure 1 est une vue en coupe représentant de façon schématique un exemple d'une cellule photovoltaïque.
La figure 2 est une vue en coupe représentant de façon schématique un autre exemple d'une cellule photovoltaïque.
Les figures 3A et 3B sont des vues en coupe représentant de façon schématique deux variantes d'un autre exemple d'une cellule photovoltaïque, respectivement dans le cas d'une cellule photovoltaïque homojonction et dans le cas d'une cellule photovoltaïque hétérojonction.
La figure 4 est une vue de dessus correspondant à la figure 3A.
Les figures 5A et 5B sont des vues en coupe représentant de façon schématique deux variantes d'un autre exemple d'une cellule photovoltaïque, respectivement dans le cas d'une cellule photovoltaïque homojonction et dans le cas d'une cellule photovoltaïque hétérojonction.
La figure 6 est une vue en coupe représentant de façon schématique une variante de la cellule photovoltaïque illustrée en figure 1.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

Pour pallier la perte de photogénération de porteurs de charges due aux contacts électriques disposés sur la face exposée au rayonnement lumineux d'une cellule photovoltaïque, les inventeurs proposent de former une région de photogénération sur les contacts électriques disposés sur la face exposée.

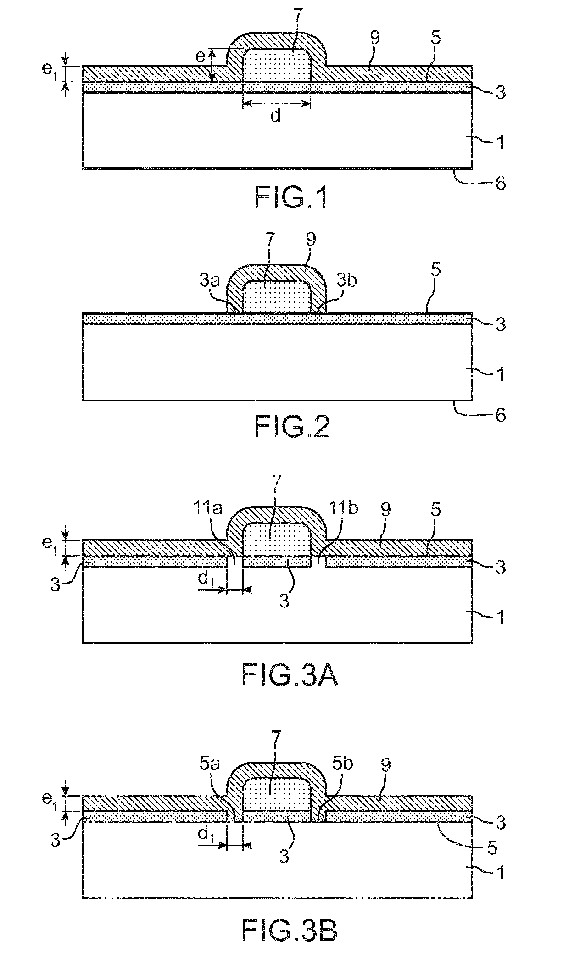

La figure 1 est une vue en coupe représentant de façon schématique un mode de réalisation d'une cellule photovoltaïque selon l'invention.

Un substrat semi-conducteur 1 comprend deux faces principales 5 et 6. La face 5 est destinée à être exposée au rayonnement lumineux. Une région semi-conductrice 3, dopée selon le type de conductivité opposé à celui du substrat 1, s'étend dans le substrat 1 à partir de la face 5. Le substrat 1 et la région 3 forment une jonction PN. La région 3 est couramment appelée émetteur.

La région 3 est par exemple réalisée par voie thermique, c'est-à-dire par insertion puis substitution d'éléments dopants dans le réseau cristallin du substrat semi-conducteur 1. On parle dans ce cas de cellule photovoltaïque de type homojonction.

Un contact électrique 7 est disposé sur la région 3. Le contact 7 est en un matériau électriquement conducteur ou en un empilement de plusieurs matériaux électriquement conducteurs.

Une couche (ou région) semi-conductrice 9 recouvre le contact conducteur 7 et la région semi-conductrice 3. La région 9 est dopée selon le même type de conductivité que la région 3, autrement dit selon le type de conductivité opposé à celui du substrat 1. Cette couche 9 est d'épaisseur sensiblement uniforme.

La région 9 constitue une région de photogénération supplémentaire, en plus du substrat 1 et de la région 3. La région 9, comme la région 3, peut être appelée émetteur.

Lorsque la cellule photovoltaïque est en fonctionnement, les porteurs de charges minoritaires du point de vue du substrat (des électrons dans le cas d'un substrat de type P et des trous dans le cas d'un substrat de type N) qui sont générés dans la région 9 sont collectés par le contact 7. Les porteurs de charges majoritaires du point de vue du substrat (des trous dans le cas d'un substrat de type P et des électrons dans le cas d'un substrat de type N) qui sont générés dans la région 9 traversent la région 3 et le substrat 1 et sont collectés par des contacts (non représentés) situés sur la face non exposée 6 de la cellule.

Le contact 7 permet de collecter des porteurs photogénérés dans le substrat 1 et les émetteurs 3 et 9.

Le niveau de dopage de la région 9 est supérieur au niveau de dopage de la région 3, de façon à permettre la migration jusqu'au substrat des porteurs majoritaires du point de vue du substrat photogénéré dans la région 9.

Avantageusement, le niveau de dopage de la région 9 varie sur l'épaisseur e₁ de cette région. Le niveau de dopage de la région 9 décroît de la surface en contact avec le contact 7 (et avec la région 3) vers la surface libre de la région 9. Un tel gradient de dopage permet d'obtenir un effet de champ supplémentaire qui favorise la collecte des porteurs minoritaires par le contact 7.

L'épaisseur e₁ de la couche 9 est par exemple comprise entre 15 nm et 85 µm, de préférence comprise entre 160 nm et 33 µm.

La région 9 présente un coefficient d'absorption par exemple compris entre 10 cm⁻¹ et 5.10⁴ cm⁻¹ à la longueur d'onde de 800 nm.

La région 9 présente une longueur de diffusion effective (L_{eff}) des porteurs de charges majoritaires du point de vue du substrat par exemple comprise entre 10 nm et 50 µm.

La largeur d et l'épaisseur e du contact 7 sont par exemple inférieures à environ 50 µm, avantageusement comprises entre 10 nm et 5 µm, et telles que la somme de la demi-largeur 0,5d et de l'épaisseur e du contact 7 soit inférieure ou égale à la longueur de diffusion effective L_{eff} définie ci-dessus (0,5d + e ≤ L_{eff}).

Un avantage d'une cellule photovoltaïque du type de celle décrite en relation avec la figure 1 réside dans le fait qu'elle peut être fabriquée à partir de tout type de substrat semi-conducteur (de qualité métallurgique ou électronique, multicristallin ou monocristallin, de type P ou N).

Un autre avantage d'une telle cellule photovoltaïque réside dans le fait qu'elle ne requiert pas de via traversant le substrat.

Un autre avantage d'une telle cellule photovoltaïque réside dans le fait qu'elle ne requiert pas d'isolation entre des zones dopées de types de conductivité opposés.

Selon une variante, au lieu d'être formée dans le substrat 1, la région 3 peut recouvrir la face 5 du substrat 1. La région 3 est par exemple réalisée par dépôt sur la face 5 du substrat 1. On parle dans ce cas de cellule photovoltaïque de type hétérojonction.

Avantageusement, dans le cas d'une cellule photovoltaïque de type hétérojonction, une couche conductrice transparente est disposée sur la région 3. Le contact conducteur 7 est disposé sur la couche conductrice transparente. La région 9 recouvre le contact 7 et la couche conductrice transparente. La couche conductrice transparente est par exemple une couche d'oxyde transparent conducteur, couramment désignée par l'acronyme d'origine anglo-saxonne TCO (« Transparent Conductive Oxide »).

La figure 2 est une vue en coupe représentant de façon schématique un autre mode de réalisation d'une cellule photovoltaïque selon l'invention. Les éléments communs avec ceux de la figure 1 sont désignés par les mêmes références.

La région 9 est disposée uniquement autour du contact 7. Hormis le contact 7, la région 9 recouvre seulement des portions 3a et 3b de la région 3, disposées en bordure du contact 7 de part et d'autre du contact 7. Il en résulte une augmentation de la contribution du substrat 1 et de l'émetteur 3 à la photogénération globale de la cellule, par rapport à une cellule photovoltaïque du type de celle illustrée en figure 1.

Le niveau de dopage de la région 9 est supérieur au niveau de dopage de la région 3, de façon à permettre la migration, jusqu'au substrat, des porteurs majoritaires, du point de vue du substrat, photogénérés dans la région 9.

Lorsque la cellule photovoltaïque est en fonctionnement, les porteurs de charges minoritaires du point de vue du substrat qui sont générés dans la région 9 sont collectés par le contact 7. Les porteurs de charges majoritaires du point de vue du substrat qui sont générés dans la région 9 passent de la région 9 à la région 3, traversent le substrat 1 et sont collectés par des contacts situés sur la face non exposée de la cellule.

Comme dans le mode de réalisation illustré en figure 1, la région 3 est par exemple réalisée par voie thermique (cas d'une cellule homojonction). Selon une alternative, la région 3 peut être réalisée par dépôt sur la face 5 du substrat 1 (cas d'une cellule hétérojonction).

La figure 3A est une vue en coupe représentant de façon schématique un autre mode de réalisation d'une cellule photovoltaïque selon l'invention, dans le cas d'une cellule de type homojonction.

La région 3, dopée selon le type de conductivité opposé à celui du substrat 1, s'étendant dans le substrat 1 à partir de la face 5, est discontinue. La région 3 est interrompue par des zones 11a et 11b du substrat 1, disposées en bordure du contact 7 de part et d'autre du contact 7.

A titre d'exemple, dans le cas d'un substrat 1 de type P, la région 3 de type N est interrompue par des zones 11a et 11b de type P.

La région 3 s'étend sous le contact 7. La région 3 s'étend également de part et d'autre du contact 7, à une distance d₁ du contact 7. La distance d₁, correspondant à la largeur des zones 11a et 11b, est par exemple sensiblement égale à l'épaisseur e₁ de la couche 9.

La région 9 recouvre le contact 7, la région 3 et les zones 11a et 11b du substrat 1. La région 9 est ainsi en contact direct avec les zones 11a et 11b du substrat 1. Ceci permet de faciliter la migration jusqu'au substrat des porteurs majoritaires du point de vue du substrat photogénérés dans l'émetteur 9.

Les régions 3 et 9 peuvent être dopées selon le même niveau de dopage. Avantageusement, le niveau de dopage de la région 9 est inférieur au niveau de dopage de la région 3.

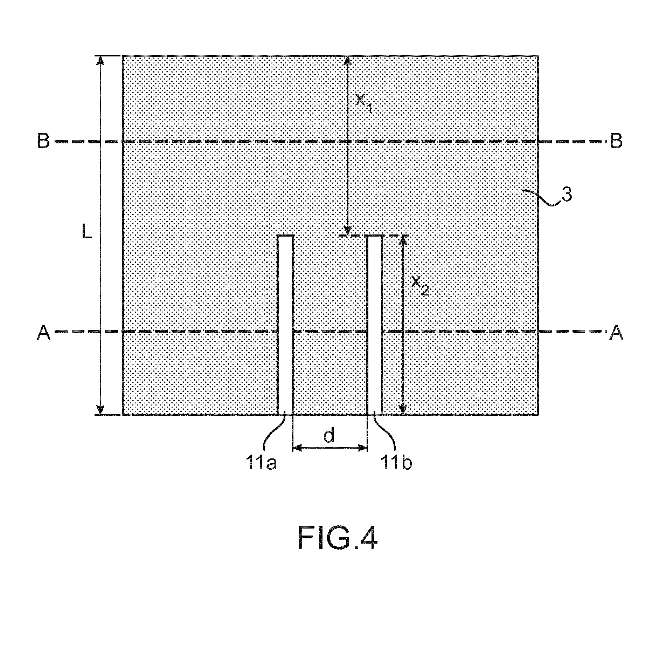

La figure 4 est une vue de dessus correspondant à la figure 3A. L'axe de coupe AA de la figure 3A est représenté par des pointillés.

La région 3 est interrompue par les zones 11a et 11b du substrat 1 seulement sur une portion X₂ de la longueur L de la région 3. Sur une portion X₁ de la longueur L de la région 3, la région 3 est continue et la vue en coupe de la cellule photovoltaïque correspond à la figure 1 (axe de coupe BB).

Avantageusement, pour une longueur L=X₁+X₂ de la région 3 comprise entre 40 nm et 2 mm, la longueur X₁ de la portion continue de la région 3 est telle que 0,1(X₁ + X₂) ≤ X₁ ≤ 0,5(X₁ + X₂).

La figure 3B est une vue en coupe représentant de façon schématique une variante de la cellule photovoltaïque illustrée en figure 3A, dans le cas d'une cellule de type hétérojonction.

La couche 3 recouvre la face 5 du substrat 1, excepté des zones 5a et 5b du substrat 1 disposées en bordure du contact 7 de part et d'autre du contact 7. La région 3 s'étend sous le contact 7. La région 3 s'étend également de part et d'autre du contact 7, à une distance d₁ du contact 7. La distance d₁ est par exemple sensiblement égale à l'épaisseur e₁ de la couche 9.

La région 9 recouvre le contact 7, la région 3 et les zones 5a et 5b du substrat 1. La région 9 est ainsi en contact direct avec le substrat 1 dans les zones 5a et 5b. Ceci permet de faciliter la migration jusqu'au substrat des porteurs majoritaires du point de vue du substrat photogénérés dans l'émetteur 9.

Les régions 3 et 9 peuvent être dopées selon le même niveau de dopage. Avantageusement, le niveau de dopage de la région 9 est inférieur au niveau de dopage de la région 3.

Comme dans la variante illustrée en figures 3A, la région 3 est discontinue seulement sur une portion X₂ de la longueur L de la région 3.

Avantageusement, pour une longueur L=X₁+X₂ de la région 3 comprise entre 40 nm et 2 mm, la longueur X₁ de la portion continue de la région 3 est telle que 0,1(X₁ + X₂) ≤ X₁ ≤ 0,5(X₁ + X₂).

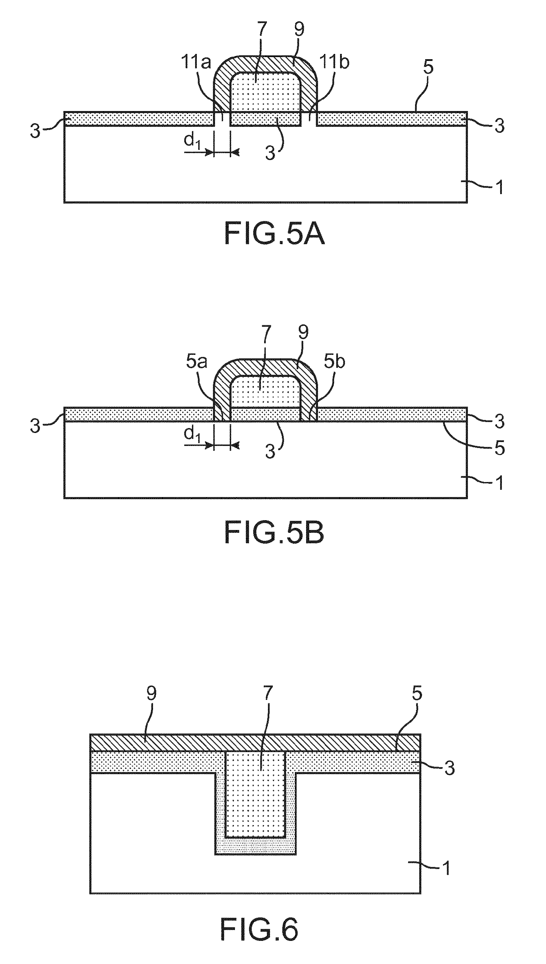

La figure 5A est une vue en coupe représentant de façon schématique un autre mode de réalisation d'une cellule photovoltaïque, dans le cas d'une cellule de type homojonction.

La région 3, s'étendant dans le substrat 1 à partir de la face 5, est discontinue. La région 3 est interrompue par des zones 11a et 11b du substrat 1, disposées en bordure du contact 7 de part et d'autre du contact 7.

La région 3 s'étend sous le contact 7. La région 3 s'étend également de part et d'autre du contact 7, à une distance d₁ du contact 7. La distance d₁, correspondant à la largeur des zones 11a et 11b, est par exemple sensiblement égale à l'épaisseur e₁ de la couche 9.

La région 9 est disposée uniquement autour du contact 7. Hormis le contact 7, la région 9 recouvre seulement les zones 11a et 11b du substrat 1. Il en résulte une augmentation de la contribution du substrat 1 et de l'émetteur 3 à la photogénération globale de la cellule, par rapport à une cellule photovoltaïque du type de celle illustrée en figure 3A.

En outre, la région 9 est en contact direct avec les zones 11a et 11b du substrat 1. Ceci permet de faciliter la migration jusqu'au substrat 1 des porteurs majoritaires du point de vue du substrat photogénérés dans l'émetteur 9.

Les régions 3 et 9 peuvent être dopées selon le même niveau de dopage.

Comme dans le mode de réalisation décrit en relation avec la figure 3A, la région 3 est discontinue seulement sur une portion X₂ de la longueur L de la région 3. Avantageusement, pour une longueur L=X₁+X₂ de la région 3 comprise entre 40 nm et 2 mm, la longueur X₁ de la portion continue de la région 3 est telle que 0,1(X₁ + X₂) ≤ X₁ ≤ 0,5(X₁ + X₂).

La figure 5B est une vue en coupe représentant de façon schématique une variante de la cellule photovoltaïque illustrée en figure 5A, dans le cas d'une cellule de type hétérojonction.

La couche 3 recouvre la face 5 du substrat 1, excepté des zones 5a et 5b du substrat 1 disposées en bordure du contact 7 de part et d'autre du contact 7. La région 3 s'étend sous le contact 7 et de part et d'autre du contact 7, à une distance d₁ du contact 7. La distance d₁ est par exemple sensiblement égale à l'épaisseur e₁ de la couche 9.

La région 9 est disposée uniquement autour du contact 7 et sur les zones 5a et 5b du substrat 1 non recouvertes par la région 3. Il en résulte une augmentation de la contribution du substrat 1 et de l'émetteur 3 à la photogénération globale de la cellule, par rapport à une cellule photovoltaïque du type de celle illustrée en figure 3B. La région 9 est également en contact avec les bords de la couche 3.

En outre, la région 9 est en contact direct avec le substrat 1 dans les zones 5a et 5b. Ceci permet de faciliter la migration jusqu'au substrat des porteurs majoritaires du point de vue du substrat photogénérés dans l'émetteur 9.

Les régions 3 et 9 peuvent être dopées selon le même niveau de dopage.

Comme dans la variante illustrée en figure 5A, la région 3 est discontinue seulement sur une portion X₂ de la longueur L de la région 3.

Avantageusement, pour une longueur L=X₁+X₂ de la région 3 comprise entre 40 nm et 2 mm, la longueur X₁ de la portion continue de la région 3 est telle que 0,1(X₁ + X₂) ≤ X₁ ≤ 0,5(X₁ + X₂).

La figure 6 est une vue en coupe représentant de façon schématique une variante de la cellule photovoltaïque illustrée en figure 1.

La face 5 du substrat semi-conducteur 1 est structurée, autrement dit une cavité s'étend dans le substrat 1 à partir de la face 5. La région semi-conductrice 3, dopée selon le type de conductivité opposé à celui du substrat 1, s'étend dans le substrat 1 à partir de la face structurée 5. La région 3 suit les contours de la cavité et comporte une portion en forme de « U ». Le contact 7 est disposé dans la cavité, sur la région 3. Comme cela est représenté, la surface supérieure du contact 7 est par exemple sensiblement au même niveau que celui de la région 3. Le contact 7 est dit « enterré » dans le substrat 1.

La région semi-conductrice 9, dopée selon le même type de conductivité que la région 3, recouvre le contact 7 et la région 3.

Le niveau de dopage de la région 9 est supérieur au niveau de dopage de la région 3, de façon à permettre la migration jusqu'au substrat des porteurs majoritaires du point de vue du substrat photogénérés dans la région 9.

Un avantage d'une telle cellule photovoltaïque réside dans le fait que le contact 7 peut être de dimensions quelconques. Afin de réduire la résistance électrique du contact 7, l'épaisseur e du contact 7 peut être augmentée sans impacter le reste de la cellule.

Selon une variante de la cellule photovoltaïque illustrée en figure 6, l'émetteur 9 peut recouvrir seulement partiellement l'émetteur 3. Il en résulte une augmentation de la contribution du substrat 1 et de l'émetteur 3 à la photogénération globale de la cellule.

Bien que le mode de réalisation de la figure 6 ait été décrit dans le cas d'une cellule photovoltaïque homojonction, il s'applique bien entendu au cas d'une cellule photovoltaïque hétérojonction.

Les cellules photovoltaïques décrites en relation avec les figures 1 à 6 peuvent profiter d'améliorations concernant les différentes régions, c'est-à-dire le substrat 1, les émetteurs 3 et 9 et le contact 7.

Pour les différents modes de réalisation décrits ci-dessus, une couche antireflet peut être mise en oeuvre sur la surface des régions 3 et/ou 9.

Un procédé de formation d'une cellule photovoltaïque du type de celle illustrée en figure 1 est décrit ci-dessous.

A partir de la face 5 d'un substrat semi-conducteur 1 destinée à être exposée au rayonnement lumineux, on forme une région semi-conductrice 3, dopée selon le type de conductivité opposé à celui du substrat 1. Le substrat 1 est par exemple un substrat de silicium monocristallin de type P.

La région semi-conductrice 3 est par exemple formée par voie thermique, par exemple par diffusion thermique. La cellule photovoltaïque en cours de formation est alors de type homojonction.

La région semi-conductrice 3 est par exemple réalisée par diffusion thermique de phosphore, par exemple à partir d'un précurseur POCl₃. On obtient alors une région 3 de type N, présentant par exemple une concentration de phosphore en surface de l'ordre de 10²⁰ cm⁻³.

Le verre de phosphore généré sur la face 5 du substrat 1 pendant le procédé de diffusion est éliminé par voie chimique (gravure humide).

On forme un contact électrique 7 en au moins un matériau conducteur sur la région semi-conductrice 3, par exemple par dépôt électrolytique (ou électro-dépôt).

Le contact 7 est par exemple formé par dépôt électrolytique d'argent. Un masque est utilisé pour protéger les zones de la région 3 sur lesquelles on ne veut pas former de matériau conducteur, de façon à obtenir le motif souhaité pour le contact conducteur 7. Le contact 7 obtenu a par exemple une largeur d de l'ordre de 2 µm et une épaisseur e de l'ordre de µm.

On recouvre le contact 7 et la région 3 d'une région semi-conductrice 9, dopée selon le même type de conductivité que la région 3 et selon un niveau de dopage supérieur à celui de la région 3.

La région semi-conductrice 9 est par exemple réalisée par dépôt d'une couche de silicium amorphe dopée de type N. La région 9 présente par exemple une concentration uniforme de phosphore supérieure à environ 10²⁰ cm⁻³. La région 9 a par exemple une épaisseur de l'ordre de 5 µm. Le coefficient d'absorption de la région 9 à la longueur d'onde de 800 nm est par exemple de l'ordre de 20 cm⁻¹. La région 9 présente par exemple une longueur effective de diffusion des trous de l'ordre de 2 µm.

Eventuellement, une fois la région 9 formée, un traitement thermique peut être effectué à une température supérieure à environ 600 °C. Un tel traitement thermique permet de recristalliser au moins en partie la région 9 de silicium amorphe. Plus la région 9 est recristallisée, plus la longueur effective de diffusion des trous dans cette région se rapproche des valeurs mesurées dans le silicium cristallin (supérieures à 20 µm). Ceci permet de favoriser la migration jusqu'au substrat des trous photogénérés dans la région 9.

La recristallisation au moins partielle de la région 9 a également pour effet de réduire le coefficient d'absorption de la région 9 aux faibles longueurs d'onde (inférieures à 700 nm). Malgré tout, l'épaisseur d'environ 5 µm choisie pour la région 9 reste suffisante pour absorber les photons correspondant au pic d'irradiance du spectre solaire (situé entre 600 nm et 700 nm). La modification des propriétés optiques de la région 9 liée à sa recristallisation partielle est donc sans impact significatif sur la photogénération dans la couche 9.

Selon une variante, au lieu d'être formée dans le substrat 1 par voie thermique, la région semi-conductrice 3 peut être formée sur la face 5 du substrat 1, par exemple par dépôt. On obtient dans ce cas une cellule photovoltaïque de type hétérojonction. Avantageusement, on recouvre la région semi-conductrice 3 d'une couche conductrice transparente, par exemple une couche d'oxyde transparent conducteur. Le contact conducteur 7 est formé sur la couche conductrice transparente.

Selon une autre variante correspondant à la figure 2, la région semi-conductrice 9 peut être formée de façon à recouvrir seulement le contact 7 et des portions 3a, 3b de la région 3 disposées en bordure du contact 7 de part et d'autre du contact 7. Pour cela, après avoir formé la couche semi-conductrice 9 sur le contact 7 et sur la région 3, on élimine les portions de la couche 9 n'entourant pas le contact 7, les portions de la couche 9 que l'on veut conserver étant protégées par un masque.

Selon une autre variante correspondant à la figure 3A, lors de l'étape de formation de la région semi-conductrice 3 par voie thermique, on forme une région 3 discontinue. Un masque permet de protéger les zones 11a et 11b du substrat 1 qu'on ne veut pas doper selon le type de conductivité opposé à celui du substrat 1. Le contact 7 est ensuite formé sur la portion de la région 3 disposée entre les zones 11a et 11b du substrat 1. On recouvre ensuite le contact 7, la région 3 et les zones 11a et 11b du substrat 1 d'une région semi-conductrice 9.

Selon une autre variante correspondant à la figure 3B, lors de l'étape de formation de la région semi-conductrice 3, on recouvre entièrement la face 5 du substrat 1 d'une couche semi-conductrice 3 puis on élimine les portions de la couche 3 recouvrant les zones 5a et 5b du substrat 1. Un masque permet de protéger les zones de la couche 3 que l'on veut conserver. Le contact 7 est ensuite formé sur la portion de la région 3 disposée entre les zones 5a et 5b du substrat 1. On recouvre ensuite le contact 7, la région 3 et les zones 5a et 5b du substrat 1 d'une région semi-conductrice 9.

Selon les variantes correspondant aux figures 3A-3B, les régions 3 et 9 peuvent être dopées selon le même niveau de dopage. Avantageusement, le niveau de dopage de la région 9 est inférieur au niveau de dopage de la région 3.

Selon deux autres variantes correspondant aux figures 5A et 5B, lors de l'étape de formation de la région semi-conductrice 9, on recouvre le contact 7, la région 3 et les zones 11a et 11b (ou 5a et 5b) du substrat 1 d'une couche semi-conductrice 9 puis on élimine les portions de la couche 9 n'entourant pas le contact 7 et ne recouvrant pas directement le substrat 1. Un masque est utilisé pour protéger les zones de la couche 9 que l'on veut conserver.

Selon les variantes correspondant aux figures 5A-5B, les régions 3 et 9 peuvent être dopées selon le même niveau de dopage.

Selon une variante correspondant à la figure 6, avant de former la région semi-conductrice 3, on forme une cavité dans le substrat 1 à partir de la face 5. On forme ensuite la région 3, dopée selon le type de conductivité opposé à celui du substrat 1, par exemple par voie thermique (cellule homojonction) ou par dépôt (cellule hétérojonction). La région 3 est formée de façon que son épaisseur soit constante par rapport à la structuration de surface du substrat 1. Dans le cas où la région 3 est formée par dépôt, on choisit un procédé permettant d'obtenir un dépôt conforme de la couche 3 sur la face 5 du substrat 1 et sur le fond et les parois de la cavité. Dans le cas où la région 3 est formée par voie thermique, on choisit un procédé permettant d'obtenir dans le substrat 1 une région 3 conforme par rapport à la structuration de surface du substrat 1. On remplit ensuite la cavité d'au moins un matériau conducteur de façon à former un contact 7, dit « enterré », sur la région 3. On recouvre ensuite le contact 7 et la région 3 d'une région semi-conductrice 9 dopée selon le même type de conductivité que la région 3 et selon un niveau de dopage supérieur à celui de la région 3.

Bien que la présente invention ait été décrite dans le cas d'une cellule photovoltaïque comprenant un seul contact conducteur disposé sur la face 5 destinée à être exposée au rayonnement lumineux, l'invention s'applique bien entendu au cas où plusieurs contacts conducteurs sont disposés sur la face 5 de la cellule photovoltaïque.

## Revendications

1. Cellule photovoltaïque comprenant :
un substrat semi-conducteur (1) dopé selon un premier type de conductivité,
une première région semi-conductrice (3), dopée selon un second type de conductivité, s'étendant à partir d'une des faces (5) du substrat, dans ou sur le substrat,
au moins un contact conducteur (7) disposé sur la première région semi-conductrice ; et
une seconde région semi-conductrice (9), dopée selon le second type de conductivité, recouvrant au moins une surface, destinée à être exposée au rayonnement lumineux, de l'au moins un contact conducteur et étant en contact avec la première région semi-conductrice et/ou le substrat.

2. Cellule photovoltaïque selon la revendication 1, dans laquelle le niveau de dopage de la seconde région semi-conductrice (9) est supérieur au niveau de dopage de la première région semi-conductrice (3).

3. Cellule photovoltaïque selon la revendication 1 ou 2, dans laquelle la première région semi-conductrice (3) recouvre ladite face (5) du substrat (1), et dans laquelle la première région semi-conductrice (3) est recouverte d'une couche conductrice transparente, l'au moins un contact conducteur (7) étant disposé sur la couche conductrice transparente.

4. Cellule photovoltaïque selon l'une des revendications 1 à 3, dans laquelle la seconde région semi-conductrice (9) recouvre entièrement la première région semi-conductrice (3).

5. Cellule photovoltaïque selon l'une des revendications 1 à 3, dans laquelle la seconde région semi-conductrice (9) est en contact seulement partiellement avec la première région semi-conductrice (3).

6. Cellule photovoltaïque selon la revendication 5, dans laquelle la seconde région conductrice (9) recouvre seulement des première et seconde zones (3a, 3b) de la première région semi-conductrice (3), disposées de part et d'autre de l'au moins un contact conducteur (7).

7. Cellule photovoltaïque selon l'une des revendications précédentes, dans laquelle la première région semi-conductrice (3) est continue, dans ou sur le substrat et sous le contact conducteur (7).

8. Cellule photovoltaïque selon l'une des revendications 1 à 4, dans laquelle la première région semi-conductrices (3) recouvre ladite face (5) du substrat (1), excepté des première et seconde zones (5a, 5b) disposées de part et d'autre de l'au moins un contact conducteur (7), la seconde région semi-conductrice (9) étant en contact direct avec les première et seconde zones (5a, 5b) du substrat (1).

9. Cellule photovoltaïque selon l'une des revendications 1 à 4, dans laquelle la première région semi-conductrice (3) s'étend dans le substrat (1) et est interrompue par une première et une seconde zones (11a, 11b) du substrat (1), dopées selon le premier type de conductivité, lesdites première et seconde zones étant disposées en bordure de l'au moins un contact conducteur de part et d'autre de l'au moins un contact conducteur (7), la seconde région semi-conductrice (9) étant en contact direct avec les première et seconde zones (11a, 11b) du substrat (1).

10. Cellule photovoltaïque selon l'une des revendications 1 à 9, dans laquelle l'au moins un contact conducteur (7) est enterré dans le substrat (1).

11. Procédé de formation d'une cellule photovoltaïque, comprenant les étapes suivantes :
a) former, à partir d'une des faces (5) d'un substrat semi-conducteur (1) dopé selon un premier type de conductivité, une première région semi-conductrice (3) dopée selon un second type de conductivité, dans ou sur le substrat,
b) former au moins un contact conducteur (7) sur la première région semi-conductrice ; et
c) recouvrir au moins une surface, destinée à être exposée au rayonnement lumineux, de l'au moins un contact conducteur (7) d'une seconde région semi-conductrice (9), dopée selon le second type de conductivité, de façon que la seconde région semi-conductrice soit en contact avec la première région semi-conductrice et/ou le substrat.

12. Procédé selon la revendication 11, dans lequel, entre les étapes a) et b), on recouvre la première région semi-conductrice (3) d'une couche conductrice transparente.

13. Procédé selon la revendication 11 ou 12, dans lequel la première région semi-conductrice (3) est réalisée de manière à être continue, dans ou sur le substrat et sous le contact conducteur (7).

14. Procédé selon l'une des revendications 11 à 13, dans lequel on réalise la première région semi-conductrice (3) afin que celle-ci recouvre ladite face (5) du substrat (1), excepté des première et seconde zones (5a, 5b) disposées de part et d'autre de l'au moins un contact conducteur (7), la seconde région semi-conductrice (9) étant en contact direct avec les première et seconde zones (5a, 5b) du substrat (1).

15. Procédé selon l'une des revendications 11 à 14, dans lequel on réalise la première région semi-conductrice (3) dans le substrat (1), afin que celle-ci soit interrompue par une première et une seconde zones (11a, 11b) du substrat (1), dopées selon le premier type de conductivité, lesdites première et seconde zones étant disposées en bordure de l'au moins un contact conducteur de part et d'autre de l'au moins un contact conducteur (7), la seconde région semi-conductrice (9) étant en contact direct avec les première et seconde zones (11a, 11b) du substrat (1).

16. Procédé selon l'une des revendications 11 à 15, dans lequel, lors de l'étape c), la seconde région semi-conductrice (9) est réalisée de manière recouvrir entièrement la première région semi-conductrice (3) ou la couche conductrice transparente.

17. Procédé selon l'une des revendications 11 à 15, dans lequel, avant l'étape a) de formation de la première région semi-conductrice (3), on forme au moins une cavité à partir de ladite face (5) du substrat (1), et dans lequel, lors de l'étape b), on forme l'au moins un contact conducteur (7) dans ladite au moins une cavité.
